# EUROPEAN PATENT APPLICATION

(11) **EP 1 278 407 A1**
(43) Date of publication of application: **22.01.2003**
(21) Application number: 01917549.6
(22) Date of filing: 28.03.2001
(51) Int. Cl.: H05K 3/46, G01R 1/067, G01R 27/02, G01R 27/04

(54) **LAMINATE WITH INSIDE LAYER CIRCUIT USED FOR MULTILAYER PRINTED CIRCUIT BOARD FOR HIGH FREQUENCY CIRCUIT, AND METHOD AND DEVICE FOR MEASURING CIRCUIT IMPEDANCE OF THE LAMINATE WITH INSIDE LAYER CIRCUIT**

(30) Priority: 25.04.2000 JP 2000124566; 06.06.2000 JP 2000169570; 08.11.2000 JP 2000340995
(71) Applicant: Matsushita Electric Works, Ltd., Kadoma-shi, Osaka-fu 571-8686 (JP); Nakashiba, Toru, Kadoma-shi, Osaka 571-8686 (JP); Matsushita, Yukio, Kadoma-shi, Osaka 571-8686 (JP); Iwaishi, Tatsumi, Kadoma-shi, Osaka 571-8686 (JP); Takedomi, Masanobu, Kadoma-shi, Osaka 571-8686 (JP); Nagaso, Mitsuhide, Kadoma-shi, Osaka 571-8686 (JP)
(72) Inventor: NAKASHIBA, Toru, Matsushita Electric Works, Ltd., Kadoma-shi, Osaka 571-8686 (JP); MATSUSHITA, Yukio, Matsushita Electric Works, Ltd., Kadoma-shi, Osaka 571-8686 (JP); IWAISHI, Tatsumi, Matsushita Electric Works, Ltd., Kadoma-shi, Osaka 571-8686 (JP); TAKEDOMI, Masanobu, Matsushita Electric Works, Ltd, Kadoma-shi, Osaka 571-8686 (JP); NAGASO, Mitsuhide, Matsushita Electric Works, Ltd., Kadoma-shi, Osaka 571-8686 (JP); AKAMATSU, Motoyuki, Matsushita Electric Works, Ltd, Kadoma-shi, Osaka 571-8686 (JP); YOSHIMITSU, Tokio, Matsushita Electric Works, Ltd., Kadoma-shi, Osaka 571-8686 (JP); KURATA, Kanji, Matsushita Electric Works, Ltd., Kadoma-shi, Osaka 571-8686 (JP)
(74) Representative: Goddar, Heinz J., Dr.
(86) International application number: JP0102571
(87) International publication number: WO01082665

(57) **Abstract**

There are provided a laminate with an inside layer circuit for use as a multilayer printed circuit board, a method for measuring a circuit impedance of the laminate, and a measuring device that enables a nondestructive impedance measurement accurately. The laminate with the inside layer circuit has a dielectric substrate, a first conductive layer disposed on an upper surface of the dielectric substrate to form a high frequency circuit, a second conductive layer disposed on a lower surface of the dielectric substrate, and a third conductive layer disposed over a first dielectric layer on the upper surface of the dielectric substrate. A test conductor is formed independently of the inside layer circuit within the first conductive layer. The test conductor has its one end exposed to an end face of the laminate such that a probe can be kept into contact with the end face to direct a high frequency signal to the test conductor with at least one of the second conductor and the third conductor both exposed to the end face being held at the ground potential.

## Description

### TECHNICAL FIELD

The present invention is directed to a laminate with an inside layer circuit for use as a multilayer circuit board for a high frequency circuit, a method and a device for measuring a circuit impedance of the laminate.

### BACKGROUND ART

Recently, multilayer circuit boards are frequently utilized to realize a high frequency circuit incorporated in an electronic device such as a mobile telephone terminal. Various kinds of multilayer circuit boards are fabricated by processing a laminate incorporating an inside layer circuit as a basic circuit. The laminate with the inside layer circuit is prepared by the following steps. Firstly, a dielectric substrate is covered on its upper and lower surfaces entirely with a first conductive layer and a second conductive layer, respectively. A basic high frequency circuit is formed within the first conductive layer with the second conductive layer being kept unprocessed. Thereafter, a third conductive layer is disposed over a first dielectric layer entirely on the first conductive layer. When the second conductive layer is formed as a ground layer to have a predetermined circuit pattern, a fourth conductive layer is disposed over a second dielectric layer entirely on the ground layer. The laminate thus fabricated to have the inside layer circuit is subsequently treated to form circuits respectively within unprocessed surfaces on opposite of the laminate in accordance with various circuit design requirements. In this regard, it is necessary to check the quality of the laminate before finally forming the circuits for improved yield. Particularly for the high frequency circuit, it is requested to make an impedance matching of the laminate to the high frequency signal running through the circuit. Therefore, a check is to be made as to whether the impedance is within a tolerable range of a design criterion such that the laminate having the impedance out of the tolerable range should be discarded as a defective product. Specifically, since the fabrication of the laminate provided with the inside layer circuit and the final circuit forming are made by separate manufactures, the above product check is always demanded.

Hitherto, TDR (Time Domain Refrectometry) technique has been utilized to measure the impedance of the circuit board. This technique is characterized to direct a pulsated or stepped high frequency incident signal to a test conductor formed within the inside conductive layer with another conductive layer being grounded, in order to detect a reflected signal within the test conductor (inside signal circuit) and obtain a reflection coefficient from the reflected signal for calculating the impedance of the test conductor (inside signal circuit).

The above impedance measurement requires a TDR measuring instrument, a signal transmitting cable, and a probe. The probe is utilized as an intermediate element for connecting the test conductor to the measuring instrument through the cable, and is therefore designed electrically to make an impedance matching with the cable as well as the test conductor in order to direct the incident signal as well as the reflected signal at a minimum loss.

When making the impedance measurement with the use of the measuring instrument and the probe, the probe is firstly brought into contact with the test conductor to obtain a measured waveform by operating the instrument. Then, it is selected from the measurement waveform a measurement region having a minimum measurement error due to a reflective noise between the probe and the test conductor such that the impedance of the test conductor can be read from the measurement waveform within the selected region.

Since the laminate with the inside layer circuit has its outermost surfaces entirely covered with the conductors, it is required to cut out a portion of the outermost conductive layer and a portion of a corresponding dielectric layer in order to bring the probe into contact with the test conductor formed as the inside layer, when measuring the circuit impedance of the laminate with the inside layer circuit in accordance with the above technique. This renders the measurement operation rather complicated and gives a certain restriction to a final circuit design. Further, when attempting to minimize the cutout in order to provide an effective circuit design area as large as possible, it becomes difficult to bring the probe into contact with the test conductor, thereby lowering measurement reliability.

### DISCLOSURE OF THE INVNETION

The present invention has been achieved to overcome the above insufficiencies and has an object of providing a laminate with an inside layer circuit for use as a multilayer circuit board for a high frequency circuit, a method and a device for measuring a circuit impedance of the laminate which enable to make a reliable impedance measurement in a nondestructive manner.

The laminate with the inside layer circuit is fabricated through the following steps. A first conductive layer and a second conductive layer are disposed respectively on an entire upper surface and an entire lower surface of a dielectric substrate. Then, a predetermined circuit pattern is formed in the first conductive layer to give an inside layer signal circuit, and at the same time a test conductor for measurement of the circuit impedance is formed independently of the inside layer signal circuit within the fist conductor in such a manner as to expose at least one end of the test conductor to an end face of the dielectric substrate. Thus formed laminate with the inside layer circuit has the end face to which the one end of the test conductor is exposed, which enables the probe to contact with the end face of the laminate while using at least one of the second conductive layer and the third conductive layer also exposed to the end face of the laminate as a ground potential, and to transmit a high frequency signal to the test conductor. With this arrangement, the impedance measurement can be made in a nondestructive manner without breaking a portion of the outermost conductive layer of the laminate with the inside layer circuit.

The dielectric laminate is preferably rectangular in shape so that the test conductor extends the full length of the dielectric substrate, which enables the impedance measurement at a particular portion within the length of the test conductor, in addition to the impedance measurement at either of the opposite end faces of the laminate.

Depending upon the type of the probe utilized, the second conductive layer may be formed with a cutout at a portion exposed to the end face of the dielectric substrate in order to prevent an accidental shorting between the test conductor and the second conductive layer.

In a preferred embodiment of the present invention, an end camera is utilized to detect the one end of the test conductor exposed to the end face of the laminate with the inside layer circuit in order to move the probe in accordance with the detected result, thereby assuring an accurate positioning of the probe relative to the test conductor.

In this connection, it is preferred to detect a positional error of the end camera relative to the probe, to store the value of the detected positional error as positional coordinates, and to move the probe based upon the value towards the one end of the test conductor for more precise positioning of the probe.

Further, after a probe needle comes into contact with the test conductor, the contacting condition may be monitored by an auxiliary camera to check any relative positional error between the probe needle and the test conductor. Therefore, when there is the positional error, it is made possible to move the probe again for another contact with the test conductor for accurate impedance measurement.

Also, it may be effective to retain the probe needle by use of pincers so as to prevent the probe needle from leaning until it comes into contact with the test conductor, which enables a precise contact of the probe needle to the test conductor as intended. In this instance, the pincers may be made of an electrically conductive material so as to remove static electricity upon the probe coming into contact with the test conductor, thereby keeping the instrument intact from the static electricity.

Similarly, upon the probe needle coming into contact with the test conductor, the probe needle may be connected to an external ground temporarily to remove the static electricity from the test conductor. Thereafter, the probe needle is connected to the instrument to direct the high frequency signal to the test conductor for measuring the impedance of the test conductor, while removing the static electricity successfully before making the measurement for protecting the instrument.

The measuring device in accordance with the present invention is preferred to include an X-Y table which moves the laminate with the inside layer circuit in X-Y directions within a horizontal plane. In case the laminate is fabricated to have therein the plural test conductors within the same horizontal plane, after making the impedance measurements for one of the test conductors by suitably positioning the probe to that test conductor, the impedance measurement of the remaining test conductors can be done easily simply by moving the X-Y table horizontally.

Further, the probe may be movable in the vertical direction so that the impedance measurement for a plurality of the laminates stacked on the X-Y table can be made successively.

The above and other advantageous features of the present invention will become more apparent from the following description when taken in conjunction with the attached drawings.

### BRIEF DESCRIPTION OF THE DRAWINGS

FIG. 1 is an exploded perspective view of a laminate with an inside layer circuit for use as a multilayer circuit board for a high frequency circuit in accordance with the present invention;
FIG. 2 is a plan view of the inside layer circuit formed in the laminate;
FIGS. 3A, 3B, 3C, 3D, and 3E are perspective views showing steps of forming the multilayer circuit board from the laminate;
FIG. 4 is a perspective view of a device for impedance measurement of the laminate with the inside layer circuit;
FIG. 5 is a perspective view of the device viewed from a different angle;
FIGS. 6A and 6B are sectional view of a probe utilized in the above device;
FIG 7 is a perspective view of a portion of the above probe;
FIG. 8 is a perspective view illustrating a contacting condition of the probe against the laminate with the inside layer circuit;
FIG. 9 is a front view illustrating a contacting condition of the probe against the laminate with the inside layer circuit;
FIG 10 is a perspective view of pincers utilized in the above device to hold a probe needle;
FIG. 11 is a schematic view of the above probe and an impedance measuring instrument;
FIG. 12 is a front view of the above device;
FIG. 13 is a flow chart illustrating the operation of the above device;
FIG. 14 is an explanatory view illustrating the operation of the above device; and
FIGS. 15A, 15B, and 15C are explanatory views illustrating the operation of the above device.

### BEST MODE FOR CARRYING OUT THE INVENTION

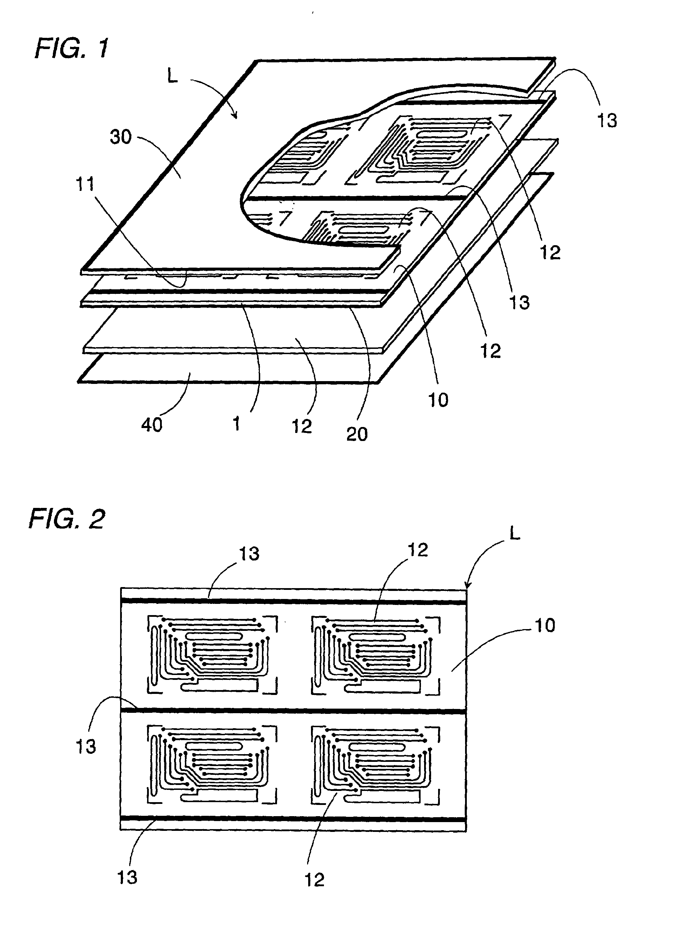

A laminate **L** provided with an inside layer circuit in accordance with the present invention is an intermediate product which is processed finally into a multilayer printed board, and includes basic high frequency circuits (hereinafter referred to as the inside layer circuits) **12** interiorly thereof and is formed on opposite outermost surfaces respectively with outer conductive layers to be finally processed into circuits. In one embodiment as shown in FIG. 1, a dielectric substrate **1** is formed on its upper and lower surfaces with a first conductive layer **10** and a second conductive layers **20** that constitute the individual inside layers. A third conductive layer **30** and a fourth conductive layer **40** are disposed respectively on a first dielectric layer **11** and a second dielectric layer **12** formed on the outer surfaces of the inside layer. In this instance, the first conductive layer **10** is processed to form the inside layer circuits **12**, while the second conductive layer **20** is utilized to form ground circuits of a final circuit design. Although not illustrated in the figures, when the intermediate product is configured to have three conductive layers, the inside layer circuit is formed in an interior conductive layer, while one of the outer conductive layer is processed into final signal circuits and the remaining outer conductive layer is formed into the ground circuits.

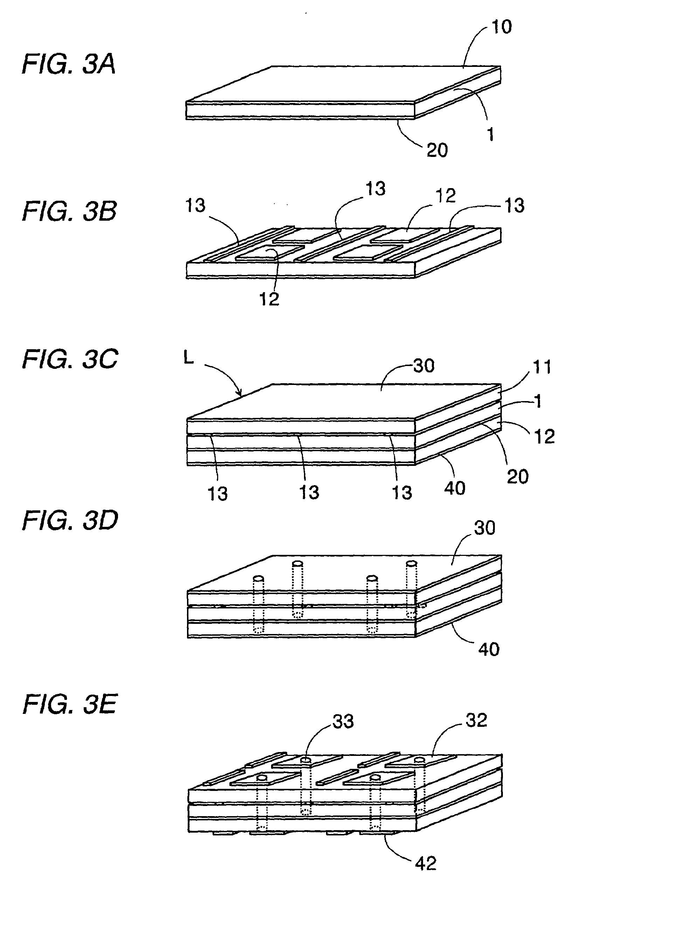

The laminate **L** with the inside layer circuits is fabricated, as shown in FIGS. 3A to 3C, by firstly depositing the first conductive layer **10** and the second conductive layer **20** on the dielectric substrate **1** and then forming the inside layer circuits **12** within the first conductive layer **10,** and forming the second conductive layer **20** into the ground circuits for later completed high frequency circuits. The first conductive layer **10** is formed with test conductors **13,** in addition to the inside layer circuits **12,** for measurement of the circuit impedance. Thereafter, the third conductive layer **30** and the fourth conductive layer **40** are formed entirely over the first conductive layer **10** and the second conductive layer **20** respectively through the fist dielectric layer **11** and the second dielectric layer **12.**

Thereafter, as shown in FIGS. 3D and 3E, the laminate **L** is processed to form desired high frequency circuits **32** and **42** respectively in the third conductive layer **30** and the fourth conductive layer **40** which are the outermost layers of the laminate **L.** Then, the inner and outer layers are interconnected by way of through-holes **33** to give the final multilayer circuit board.

As shown in FIG. 2, the first conductive layer **10** is formed with a plurality of the identical inside layer circuits **12,** and the other conductive layers are formed respectively with a plurality of circuits such that the final multilayer circuit board is cut into a plurality of circuit components simultaneously. As shown in the figure, each of the plural test conductors **13** is formed to extend the full length of the laminate **L** to have its longitudinal ends exposed to end faces of the laminate **L**. In this connection, the second conductive layer **20** after being formed into the ground circuits has its edges exposed to the end faces of the laminate **L**, thereby acting to provide a reference potential, i.e., the ground potential relative to the test conductors **13.**

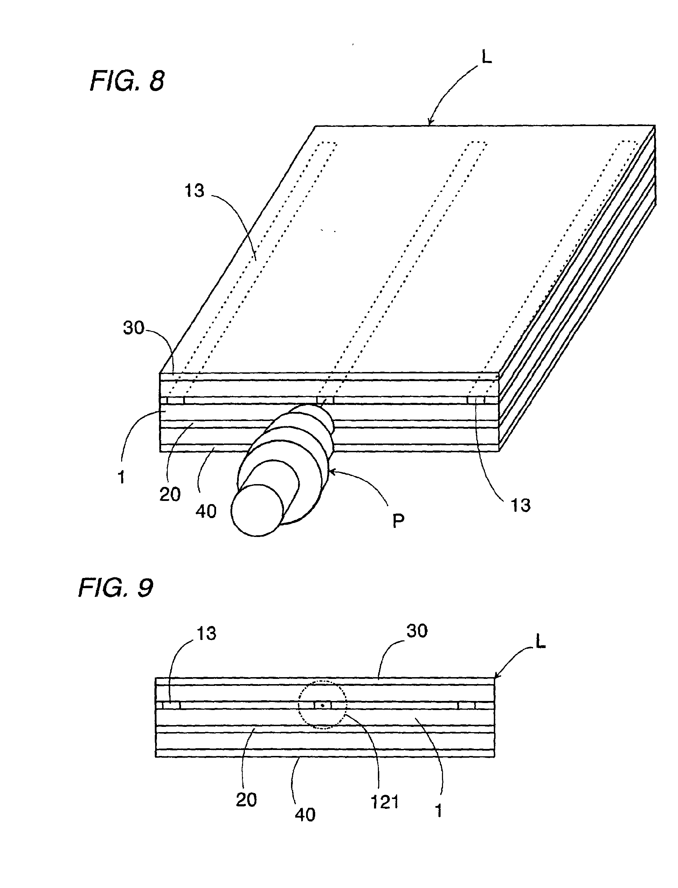

The impedance measurement is made by use of a probe **P** specifically designed for the laminate **L,** an instrument **200** which transmits a high frequency signal to the test conductor **13** by way of the probe and analyzes a reflecting wave from the test conductor, and a coaxial cable **50** connecting the instrument to the probe **P.** As shown in FIGS. 8 and 9, the probe **P,** which includes a probe needle **111** and a ground electrode **120,** is set to bring the probe needle **111** into contact with one end of the test conductor **13** and at the same time to bring an annular contacting edge **121** at the front of the electrode **120** into contact with the second conductive layer **20** and/or the third conductive layer **30,** in order to make the impedance measurement of the inside layer circuit. The instrument **200** includes an oscilloscope and an input signal generator providing the high frequency signal for the measurement. It is noted here that since the test conductor **13** extends the full length of the laminate, it is possible to measure the impedance at any point along the length of the test conductor **13** by analyzing the reflected high frequency signal in consideration of the elapsed time. Also because of that the test conductor **13** is exposed to the opposite end faces of the laminate **L,** the impedance measurement can be made at any one of the opposite faces.

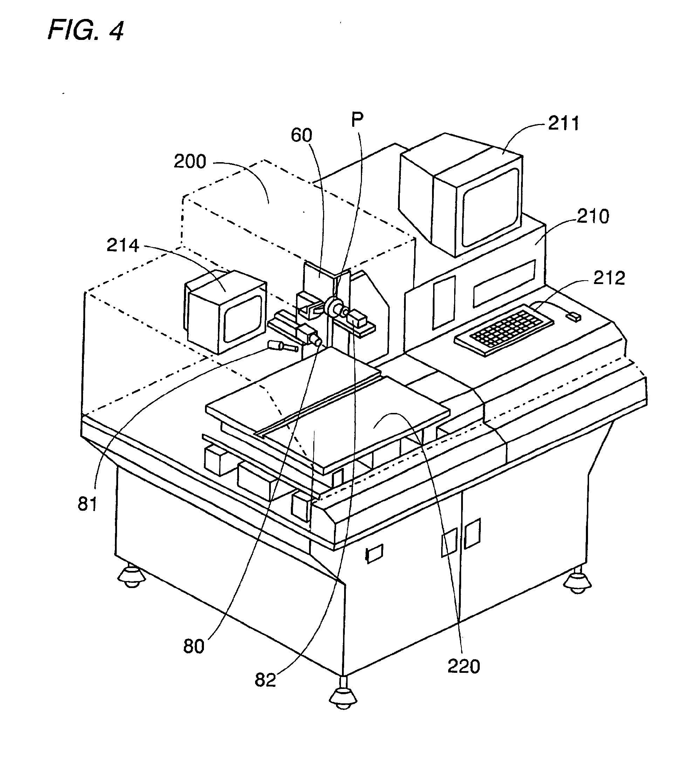

FIG. 4 illustrates an impedance measurement device for measuring the impedance. The device includes a personal computer **210,** a probe drive means **60,** the instrument **200,** an end camera **80,** an auxiliary camera **81,** a positional error detecting camera **82,** and an X-Y table **220.** The personal computer **210,** which is provided with a monitor **211** and a keyboard **212,** makes an overall control including operating the instrument **200** to obtain the wave for the impedance measurement, reading out the impedance from the wave and data processing. Thus, the personal computer **210** controls a pattern of the operations for the impedance measurement, constituting an automatic impedance measurement system.

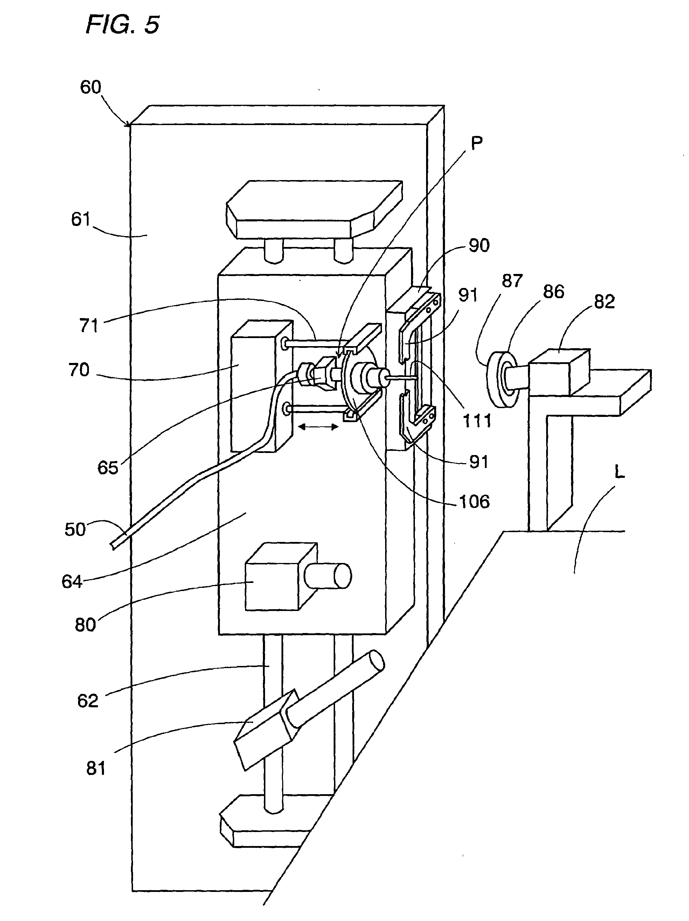

The probe drive means **60** is provided to move the probe **P** and the end camera **80** in the vertical direction (Z-direction) and is accompanied with a servo mechanism for fine adjustment of the position of the probe **P.** As shown in FIG. 5, the probe drive means **60** includes a hoist block **64** which carries the probe **P** and the end camera **80** and which is guided to move up and down along vertical guides **62** fixed to a prop **61.** The probe **P** is fixed at its rear end to the hoist block **64** by means of a nut **65.** Further, the hoist block **64** includes a drive mechanism **70** for moving the ground electrode **120** in the directions as indicated by arrows in the figure and a bracing mechanism **90** for steadily bracing the probe needle **111.** The drive mechanism **70** has a pair of upper and lower actuator rods **71** which catch a mounting flange **106** of the probe **P,** and operates to move the ground electrode **120** horizontally by driving the actuator rods **71,** as will be explained later.

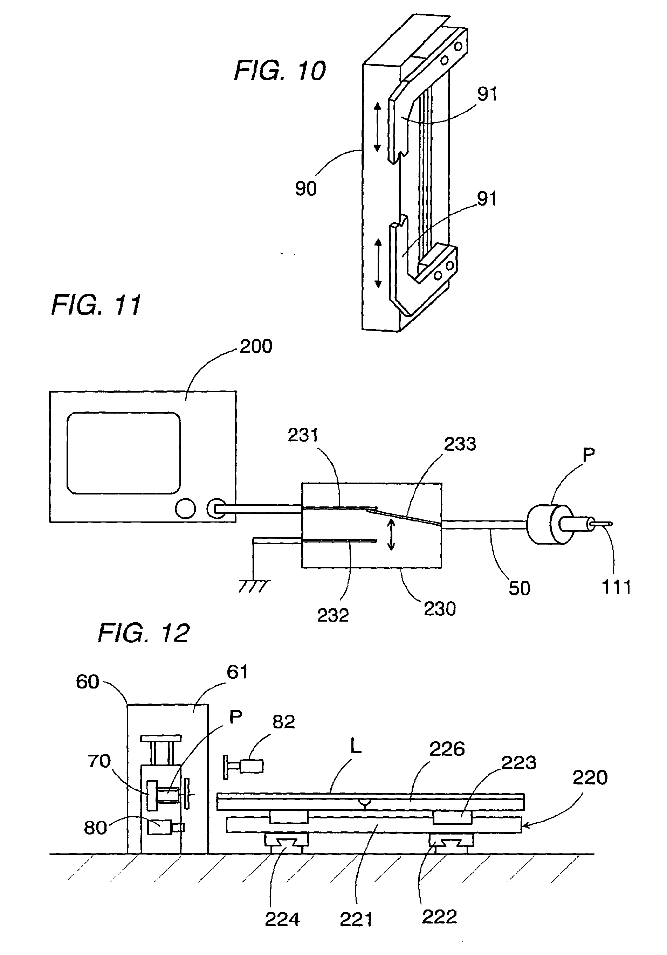

The bracing mechanism **90** includes, as shown in FIG. 10, a pair of pincers **91** which are caused by a drive cylinder to move vertically towards and away from each other. The pincers **91** are made of an electrically conductive stainless steel and is grounded to a ground of the impedance measurement device.

As shown in FIG. 11, a switch means (a static electricity removing device) **230** is provided midway along the coaxial cable **50** connecting the probe **P** and the instrument **200.** The switch means **230** includes an instrument side terminal **231** electrically connected to the instrument by way of the center conductor of the coaxial cable **50,** a ground terminal **232** connected to the ground, and a movable contact **233** which is electrically connected to the probe needle **111** of the probe **P** by way of the center conductor of the coaxial cable **50** and is capable of being selectively connected to one of the instrument side terminal **231** and the ground terminal **232.** When the movable contact **233** is switched to the instrument side terminal **231,** the impedance measurement is made ready. When the movable contact **233** is switched to the ground terminal **232,** the probe needle **111** is grounded. The switching of the movable contact **233** is controlled by the personal computer **210** so that the movable contact **233** is kept connected to the ground terminal **232** to remove the static electricity when the probe needle **111** comes firstly into contact with the test conductor **13,** after which the movable contact **233** is switched to the instrument side terminal **231** for the impedance measurement.

The end camera **80,** the auxiliary camera **81,** and the positional error detection camera **82** are provided to ensure an accurate contact of the probe **P** with the test conductor **13.** The end camera **80** gives an image of an exposed area of the test conductor **13** at the end face of the laminate **L** to detect coordinates of the center of the test conductor. The positional error detection camera **82** is provided to detect a positional error of the probe **P** relative to the end camera **80.** Disposed forwardly of the positional error detecting camera **82** is an illuminator **86** having a glass-made scale plate **87** marked with a reference scale **88.**

The auxiliary camera **81** is mounted below the hoist block **64** to monitor the condition of the probe **P** after the probe **P** is brought into contact with the test conductor **13** for confirmation of any positional error between the probe **P** and the test conductor **13.** The images taken by the end camera **80** and the auxiliary camera **81** are displayed on a monitor **214.**

As shown in FIG. 12, the X-Y table **220** is provided to fixedly carry the laminate **L** and move it horizontally in order to oppose the end face of the laminate **L** to the probe **P,** and is disposed in front of the probe drive means **60** and below the positional error detection camera **82.** The X-Y table **220** is capable of moving in X-Y directions by means of an X-direction rail **221,** a Y-direction rail **222,** and a combination thereof, and is provided with a suction platform **226** for fixing the laminate **L** thereon by suction.

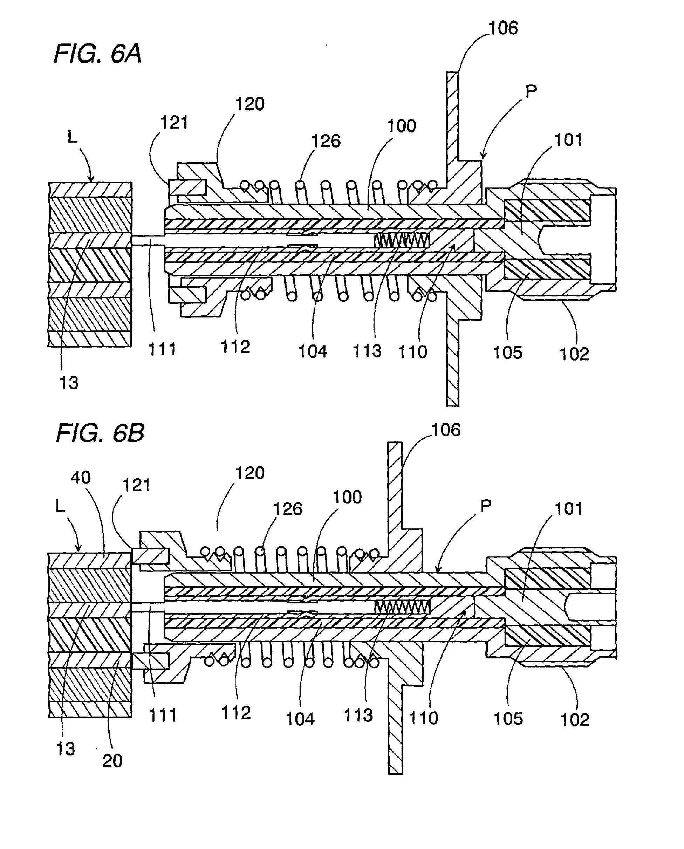

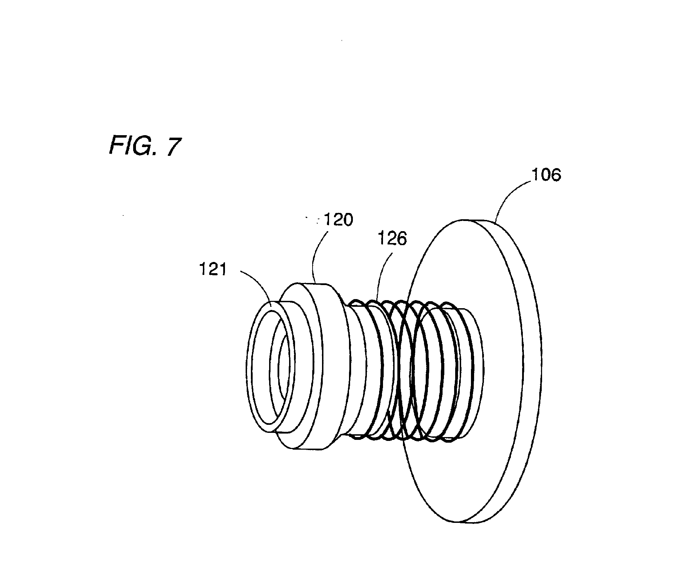

The probe **P** utilized in the present invention includes, as shown in FIGS. 6 and 7, a metal-made main cylinder **100** having at its rear end a socket **101** into which a center pin of the coaxial cable **50** is inserted, a needle unit **110** received within the main cylinder **100,** and the ground electrode **120** fitted over the main cylinder to be slidable along an axial direction of the main cylinder. The rear end of the main cylinder **100** has a threaded portion **102** for coupling with a nut integral with an outer conductor of the coaxial cable **50.** The threaded portion **102** is also utilized to secure the probe **P** to a mounting nut **65** of the hoist block **64.** The needle unit **110** includes the probe needle **111** and a holder **112** which supports the probe needle so that the probe needle is capable of moving along the axial direction. The probe needle **111** is biased forwardly by a spring **113** held within the holder **112.** The holder **112** is electrically connected to the probe needle **111** and also to the socket **101** receiving the center pin of the coaxial cable **50.** The holder **112** and the socket **101** are electrically isolated from the main cylinder **100** respectively by dielectric sleeves **104** and **105.** Fitted into the front end of the ground electrode **120** is an annular contact brim **121** made of an electrically conductive rubber which surrounds the probe needle **111** coaxially. Formed around the main body **100** rearwardly of the ground electrode **120** is the mounting flange **106** which is axially movable and is coupled to the ground electrode **120** by means of a coil spring **126.** As shown in FIG. 5, the mounting flange **106** is secured to the actuator rods **71** of the drive mechanism **70** so as to be forced thereby through the coil spring **126** to project the contact brim **121** of the ground electrode **120** to the same extent as the probe needle **111,** as shown in FIG. 6B, bringing the brim into contact with the second conductive layer **20** as well as the third conductive layer **30** exposed on the end face of the laminate **L**. The probe **P** is designed to have the same impedance (e.g. passband characteristic Z0 = 50 Ω ± 1 Ω for 10 GHz) as the coaxial cable **50** to have the impedance matching therewith.

Since the contact brim **121** of the ground electrode **120** is made of the electrically conductive rubber, it is possible to obtain a suitable contacting pressure due to an elastic resiliency inherent to the rubber and to protect the contact brim **121** as well as the corresponding conductive layers from being damaged. The electrically conductive rubber, which exhibits a lower resistance than a conventional rubber even in the absence of a pressure strain, gives the same electrical conductivity as a conventional electrically conductive metal and exhibits less resistance variation when it is compressed. For example, the electrically conductive rubber is available from a product "EC-A" manufactured by "SHIN-ETSU CHEMICAL CO. LTD". Instead, the contact brim **121** may be made of a pressure sensitive conductive rubber which exhibits the same electrical conductivity as the rubber in a normal condition, but lowers the resistance as being compressed to have the same conductivity as the conductive meal. For example, the pressure conductive rubber is available from a product "PCR" manufactured by "JSR CORPORATION."

The probe needle **111** is designed, for example, to have a diameter of 100 µm at its front end and a diameter of 300 µ at the remaining portion for the test conductor **13** having a **18** µm thickness. Since the probe needle **111** is movable axially relative to the holder **112** and is biased forwardly by the spring **113,** the probe needle **111** can came into contact with the test conductor **13** at a suitable pressure for reliable electrical connection therewith. Also due to the action of the spring, an excess impact can be prevented from acting on the laminate **L** and the front end of the probe needle **111.**

The dielectric sleeves **104** and **105** are preferred to be made of a material having a low dielectric constant and dielectric dissipation factor for improved high frequency characteristics. For example, a fluorine resin such as PTFE (polytetrafluoroethylene) and a resin such as PPO (polyphenylene oxide) and PPE (polyphenylene ether) can be utilized as the sleeves. It is equally possible to use any other material having the same dielectric constant and dielectric dissipation factor and the same dimensional stability as the fluorine resin.

Since the probe needle **111** is removable from the holder **112,** it can be replaced when worn out. When the probe **P** is fixed to the hoist block **64,** the probe needle **111** is disposed between the pincers **91** of the bracing mechanism **90** at the front of the hoist block **64** so that the pincers **91** catch the probe needle **111** while the probe **P** is advanced towards the end face of the laminate **L,** thereby preventing the probe needle **111** from leaning until the needle comes into contact with the test conductor **13.** Upon completion of the contact, the probe needle **111** is released from the pincers.

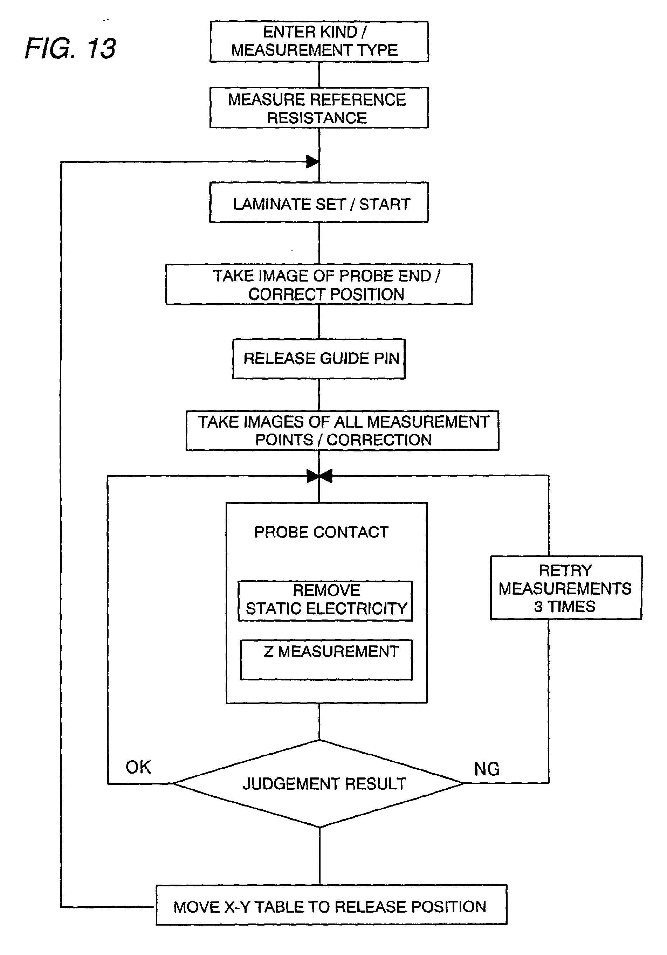

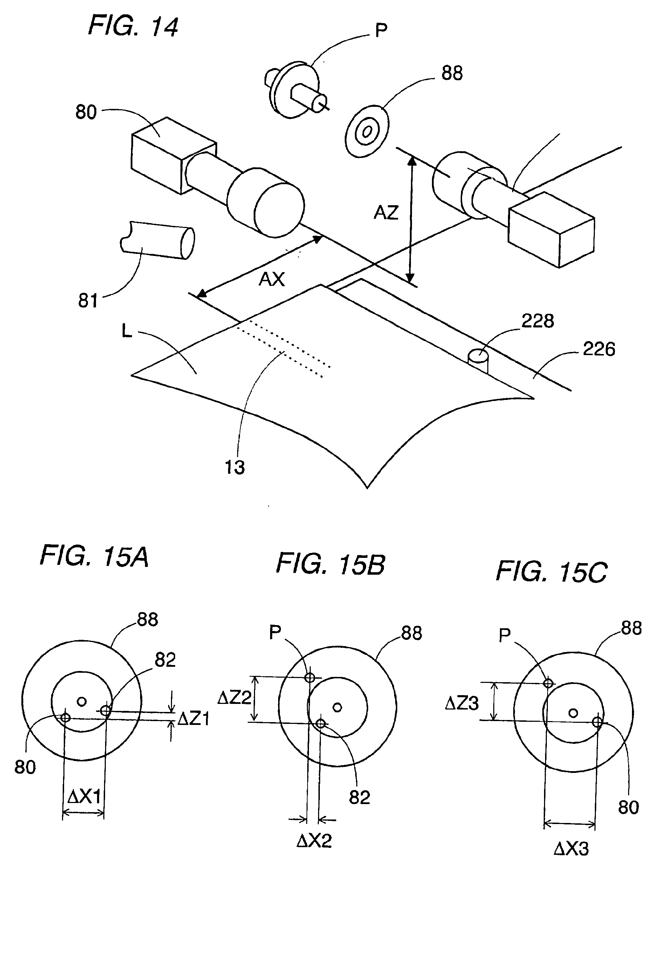

With reference to the flow chart of FIG. 13, the steps of measuring the impedance of the test conductor **13** of the laminate **L** will be now explained. Firstly, it is made to enter into the personal computer **210** a measurement type identifying the kind of the laminate **L** and the high frequency for which the impedance measurement is to be made. Then, the device is initialized by making a measurement of a reference resistance. Thereafter, the laminate **L** is placed on the suction table **226** of the X-Y table **220** and is fixed thereto by suction. As shown in FIG. 14, a guide pin (stopper pin) is disposed to project from the outside portion of the suction table **226** against which the laminate **L** abuts so to be positioned on the table.

Subsequently, a correction is made to determine a contact position of the probe **P** to the laminate **L**. The correction is made by obtaining a correction amount (distance) between the end camera **80** and the probe **P,** obtaining a positional correction amount of the test conductor **13** of the laminate **L,** obtaining an error for contacting the probe **P** to the test conductor **13,** and finally obtaining a minute error in the Z-direction followed by integrating these values to make the correction for determining the contact position of the probe **P** to the laminate **L.**

The correction amount between the end camera **80** and the probe **P** is obtained by moving the hoist block **64** vertically to locate the end camera **80** in an opposed relation to the positional error detecting camera **82** with the reference scale **88** interposed therebetween, then, as shown in FIG. 15A, taking a difference ΔZ1 in the Z-direction and a difference ΔX1 in the X-direction between the end camera **80** and the positional error detecting camera **82** with respect to the reference scale **88.** Thereafter, as shown in FIG. 14, the hoist block **64** is lowered to locate the positional error detecting camera **82** in an opposed relation to the probe **P** with the reference scale **88** interposed therebetween, followed by taking an image of the probe **P** with the positional error detecting camera **82,** as shown in FIG. 15B, to obtain a difference ΔZ2 in the Z-direction and ΔX2 in the X-direction between the probe **P** and the positional error detection camera **82** with respect to the reference scale **88.** Subsequently, as shown in FIG. 15C, thus obtained ΔZ1 and ΔZ2 are processed to calculate a positional error ΔZ3 in the Z-direction between the end camera **80** and the probe **P,** while thus obtained ΔX1 and ΔX2 are processed to calculate a positional error ΔX3 in the X-direction between the end camera **80** and the probe **P,** thereby providing a relative positional error between the probe **P** and the end camera **80.**

Next, the guide pin **228** is lowered to be released from the abutment with the laminate **L.** Then, the end camera **80** is operated to take an image of the end face of the laminate **L.** The image is taken while moving the suction table **226** of the X-Y table in the X-direction to move the laminate **L** in the X-direction relative to the end camera **80.** When there is found within a recognition view a cross section which is identical to a cross sectional pattern of the test conductor **13** already registered in the microcomputer **210,** positional error amounts (ΔX4 and ΔZ4) are obtained as the coordinates of the center of the test conductor **13.** ΔX4 is a distance measured from one end of a viewfield of the end camera **80** to the center of the test conductor **13** in the X-direction, while ΔZ4 is a distance measured from one end of the viewfield of the end camera **80** to the center of the test conductor **13** in the Z-direction. Thus obtained positional error amounts of the test conductor **13** are fed to the personal computer **210** to be stored thereat. The positional error amounts of the test conductor **13** are obtained for all points of the end face of the laminate **L** where the impedance measurements are intended.

Then, the error amounts (ΔX3 and ΔZ3) thus obtained for the end camera **80** and the probe **B,** and the positional error amounts (ΔX4 and ΔZ4) for the test conductor **13** are added (summed up) to provide an error for contacting the probe **P** to the test conductor **13.** Subsequently, the hoist block **64** is lowered in accordance with the error to bring the end of the laminate **L** in an opposed relation to the probe **B.** Subsequently, a pair of the pincers **91** are caused to move towards each other to pinch the probe needle **111,** thereby facilitating the contact with the test conductor **13** on the end face of the laminate **L.**

Thereafter, the suction table **226** of the X-Y table **220** is moved towards the probe **P** in the Y-direction in order to bring the end of the probe needle **111** into contact with the end of the test conductor **13** exposed on the end face of the laminate **L,** as shown in FIG 6A. In this condition, the rods **71** of the drive mechanism **70** retreat to keep the contact brim **121** of the ground electrode **120** receded with respect to the probe needle **111,** thereby easily confirming the contact of the probe needle **111** with the end face of the laminate **L.**

Immediately before or upon contacting of the probe needle **111** to the test conductor **13,** the probe needle **111** is released from the pincers **91.** When the bracing of the probe needle **111** is released upon contacting of the needle to the test conductor **13,** the static electricity accumulated in the test conductor **13** can be removed. Further, since the movable contact **233** is kept connected to the ground terminal **232** when the probe needle **111** comes first into contact with the test conductor **13,** it possible to remove the static electricity by way of the probe needle **111.** In this manner, the present invention can provide a double protection for removing the static electricity by means of the pincers **91** and also by the switch means **230,** thereby preventing the static electricity from flowing into the instrument **200** and therefore protecting the instrument from being damaged by the static electricity.

Further, since the probe **P** is caused to move only after obtaining the error for contacting the probe **P** to the test conductor **13,** it is possible to locate the probe into a nearly accurate position prior to contacting the probe needle **111** with the test conductor **13.** However, it may be possible that the probe **P** is misaligned so that the probe needle **111** fails to come into contact with the exposed face of the signal circuit **4** due to pitching or yawing of the probe moving means **60.** If the probe needle **111** fails to contact with the test conductor **13,** the condition is monitored by the auxiliary camera **81** to confirm the misalignment of the probe **P** with the test conductor **13** and obtain a minute error in the Z-direction between the test conductor **13** and the probe **P** such that the servo mechanism of the probe moving means **60** can move (once again) the probe **P** based upon the error for correcting the position of the probe **P.** With this correction, the probe **P** can be brought into contact (once again) successfully with the test conductor **13.**

Next, the movable contact **233** of the switch means **230** is switched to the instrument side terminal **231** and at the same time the rods **71** of the drive mechanism **70** advance the mounting flange **106** to move the ground electrode **120** forwardly towards the laminate **L,** thereby contacting the contact brim **121** to the ends of the conductive layers **20** and **30** above and below the test conductor **13.** Then, the pulsed or stepped high frequency incident signal is transmitted from the instrument **200** through the cable **50** to take the reflected signal from the test conductor **13** into the instrument **200.** A reflecting coefficient obtained from the reflected signal is utilized in the instrument **200** to measure the impedance of the test conductor **13.** Thereafter, when the measuring result is judged as a proper result, the rods **71** of the drive mechanism **70** retreat to move the ground electrode **120** back so as to release the contact brim **121** from the conductive layers **20** and **30.** At the same time, the suction table **226** of the X-Y table **220** is driven to move away from the probe **P** along the Y-direction to release the probe needle **111** from the test conductor **13.** Subsequently, the suction table **226** of the X-Y table **220** is driven to move in the X-direction to locate it in the next measurement position in an opposed relation to the probe **P,** after which the above steps are repeated sequentially to measure the impedance of the laminate **L** at all the measuring points. The measured impedances are stored in the personal computer **210** to complete the impedance measurement for the one sheet of the laminate **L.** It is noted that when the measurement result at one point is judged to be improper, three more measurements are repeated. After making the impedance measurements at all the measurement points, the X-Y table **220** is caused to move to a pick-out position of the laminate **L** to be ready for picking out another laminate **L**.

As discussed in the above, the impedance measurement in accordance with the present invention utilizes the end camera **80,** the auxiliary camera **81,** the positional error detecting camera **82,** the bracing mechanism **70,** the switch means **230,** the X-Y table **220,** and the probe moving means **60** for measurement of the test conductor **13** exposed on the end face of the laminate **L** are systematized so as to be controllable by the personal computer **210.** Therefore, it is possible to integrate all these units for building up an automatic impedance measurement system specific to the impedance measurement of the test conductor **13** exposed on the laminate **L** by integrating all the units.

## Claims

1. A laminate with an inside layer circuit for use as a multilayer printed circuit board for a high frequency circuit, said laminate comprising:
a dielectric substrate;
a first conductive layer disposed on an upper surface of said dielectric substrate to form a high frequency circuit;
a second conductive layer disposed on a lower surface of said dielectric substrate;
a third conductive layer disposed over a first dielectric layer on the upper surface of said dielectric substrate; and
a test conductor formed independently of the inside layer circuit within said first conductive layer for measurement of a circuit impedance, said test conductor having its one end exposed to said laminate.

2. The laminate as set forth in claim 1, wherein
said dielectric substrate is rectangular in shape, and said test conductor extends a full length of said dielectric substrate to have its lengthwise ends exposed to the lengthwise ends of said dielectric substrate.

3. The laminate as set forth in claim 1, wherein
said second conductive layer is formed with a cutout at a portion exposed to an end face of said dielectric substrate.

4. A method for measuring a circuit impedance of a laminate with an inside layer circuit, said method comprising the steps of:
advancing a probe, which has a probe needle directing a high frequency signal and a ground electrode, to an end face of the laminate with the inside layer circuit as defined in claim 1, in order to bring the probe needle in contact with the test conductor exposed on the end face of said laminate and at the same time to bring the ground electrode in contact with at least one of the second conductive layer and the third conductive layer;
directing the high frequency signal to said test conductor; and
analyzing a high frequency signal reflected back from the test conductor to measure an impedance characteristic of the high frequency circuit.

5. The method as set forth in claim 4, wherein
an end camera is utilized to detect the end of the test conductor exposed to the end face of said laminate with the inside layer circuit, and the positioning of the probe with respect to the test conductor is made according to the detected result.

6. The method as set forth in claim 5, wherein
said method includes steps of detecting a positional error of the probe relative to the end camera, storing a value of the positional error as position coordinates of the test conductor, and moving the probe towards one end of the test conductor in accordance with the value.

7. The method as set forth in claim 5, wherein
said method includes steps of utilizing an auxiliary camera to monitor a contacting condition of the probe needle after bringing the probe needle into contact with the test conductor, and confirming a positional error between the test conductor and the probe needle contacting with the test conductor.

8. The method as set forth in claim 7, wherein
said method further includes steps of detecting a value indicative of the positional error and moving the probe again according to said value to bring the probe in another contact with the test conductor.

9. The method as set forth in claim 5, wherein
said probe needle is held by pincers until it comes into contact with the test conductor in order to prevent the probe needle from leaning.

10. The method as set forth in claim 9, wherein
the impedance of the test conductor is measured after removing static electricity from the test conductor by said pincers.

11. The method as set forth in claim 5, wherein
said method includes steps of connecting the probe needle temporarily to an external ground to remove the static electricity, connecting the probe needle to an external high frequency signal generating circuit to direct the high frequency signal to the test conductor, and measuring the impedance of the test conductor.

12. A device for measuring a circuit impedance of the laminate with the inside layer circuit as defined by claim 1, said device comprising:
a probe having a probe needle directing a high frequency signal and a ground electrode;
a measuring instrument connected to the probe through a cable; and
a moving means for moving the probe relative to the laminate;
wherein the moving means advances the probe to the end face of the laminate so as to bring the probe needle into contact with the end of the test conductor and at the same time bring the ground electrode into contact with at least one of the second conductive layer and the third conductive layer exposed on the end face of the laminate,
said measuring instrument measuring the circuit impedance based upon the high frequency signal reflected back from the test conductor

13. The device as set forth in claim 12, further including
an end camera which detects the end of the test conductor exposed to the end face of said laminate with the inside layer circuit, said moving means operating to advance the probe towards the laminate based upon the detected result of the end camera.

14. The device as set forth in claim 13, further including
an auxiliary camera which monitors a contacting condition of the probe needle after coming into contact with the test conductor in order to detect a positional error between the test conductor and the probe,
said moving means operating to advance the probe towards the end face of the laminate in consideration of the positional error.

15. The device as set forth in claim 13, further including
an auxiliary camera which monitors a contacting condition of the probe needle after coming into contact with the test conductor in order to confirm a positional error between the test conductor and the probe needle, said moving means operating to move the probe again when there is detected such positional error.

16. The device as set forth in claim 12, further including
pincers which hold the probe needle until the probe needle comes into contact with the test conductor in order to prevent the probe needle from leaning.

17. The device as set forth in claim 16, wherein
said pincers are made of an electrically conductive material and is connected to the ground.

18. The device as set forth in claim 12, including
a switch means for switching a signal I/O line of a cable connecting the probe and the measuring instrument to the ground.

19. The device as set forth in claim 12, including
an X-Y table for moving the laminate with the inside layer circuit within a horizontal plane in X-Y directions.

20. The device as set forth in claim 19, wherein
said moving means operates to move the probe in a vertical direction relative to the laminate with the inside layer circuit.
